# EUROPÄISCHE PATENTANMELDUNG

(11) **EP 0 833 550 A2**
(43) Veröffentlichungstag der Anmeldung: **01.04.1998**
(21) Anmeldenummer: 97116679.8
(22) Anmeldetag: 25.09.1997
(51) Int. Cl.: H05K 1/02, H01R 9/07, H01R 43/02, G01K 7/18

(54) **Leiterplatte mit Zugentlastung für Anschluss-Kabel, Verfahren zu deren Herstellung und Verbindung sowie deren Verwendung**

(30) Priorität: 30.09.1996 DE 19640058
(71) Anmelder: Heraeus Sensor-Nite GmbH, 63450 Hanau (DE)
(72) Erfinder: Damaschke, Gerhard, 65439 Flörsheim (DE); Schlag, Frank, 21218 Seevetal-Hittfeld (DE); Wienand, Karlheinz, Dr., 63741 Aschaffenburg (DE)
(74) Vertreter: Kühn, Hans-Christian

(57) **Zusammenfassung**

Eine Leiterplatte mit wenigstens einem Bauelement als Meßwiderstand, Heizwiderstand oder Meßelektroden-Anordnung weist wenigstens zwei mit Leiterbahnen verbundene Kontaktfelder zur elektrischen und mechanisch festen Verbindung mit abisolierten Leiterenden eines ummantelten Anschlußkabels auf, wobei das Kabelende mit seinem äußeren Mantel in einem gegenüber der Leiterplatte unverrückbar angeordneten Halterungselement mit Abstand zum Kontaktfeld der Leiterbahn positionierbar ist; in einer bevorzugten Ausführungsform weist das Halterungselement kanalartige Ausnehmungen zur Klemm-Befestigung des Leitermantels auf, die mit ihrem Leiteraustrittsbereich benachbart zu jeweils einem Kontaktfeld der Leiterplatte benachbart angeordnet ist.

## Beschreibung

Die Erfindung betrifft eine Leiterplatte, bei der eine elektrisch leitende und mechanisch feste Verbindung der Leiterbahn über Kontaktfelder mit wenigstens zwei gegeneinander elektrisch isolierten Anschluß-Leitern eines Anschluß-Kabels vorgesehen ist, wobei die Kontaktfelder der Leiterbahn an abisolierte Leiter-Enden wenigstens eines ummantelten Anschluß-Kabels durch einen Schmelzvorgang anschließbar sind und wobei das Kabel-Ende in einem gegenüber der Leiterbahn unverrückbar angeordneten Halterungs-Element mit Abstand zur Kontaktfläche der Leiterbahn positionierbar ist, sowie ein Verfahren zum Herstellen einer Leiterplatte und zum Verbinden von Anschluß-Leitern sowie eine Verwendung der Leiterplatte.

Aus der JP-8-32228 (A) ist es bekannt, elektrische Leiter einer Leiterplatte mit einem Draht oder mit dem Leiter einer anderen Leiterplatte zu verbinden ohne das Erfordernis von zusätzlichen Anschluß-Verbindungs-Komponenten; die Leiterplatte weist mit Ausnehmungen versehene Verbindungskontakte auf, in die die Draht-Enden eingeführt und mit den auf der Platte befindlichen Leitern durch Löten oder Schweißen verbunden werden.

Weiterhin ist es aus der GB 22 53 521 A bekannt, ein Koaxialkabel mit einer Leiterplatte zu verbinden, die zumindest eine Leiterbahn aufweist, die wenigstens im Bereich der Kontaktfläche als Ebene ausgebildet ist; dabei weist die Leiterplatte eine Ausnehmung zur Aufnahme eines Endes des Koaxialkabels auf, so daß der Innenleiter des Kabels direkt mit einem Kontaktpunkt der Leiterplatte ohne Krümmung verbunden werden kann.

Weiterhin ist es aus der US 33 83 457 bekannt, ein Koaxialkabel mit Leiterpfaden einer elektrischen Leiterplatte zu verbinden, wobei ein zu einer Kontaktstelle benachbartes Halterungselement mit einer kanalartigen Ausnehmung angegeben ist.

Aus der DE 24 41 559 A1 ist eine Vorrichtung zum Anschließen von Flachbandkabeln an eine Leiterplatte bekannt, wobei zu verlötende Enden von Leitungsadern im Raster von Kontaktbohrungen der Leiterplatte parallel zueinander gerichtet sind.

Als problematisch erweisen sich die bekannten Verbindungen im Hinblick auf die Automatisierung, wobei insbesondere bei einer automatisierbaren Montage von Leiterplatten mit Schwierigkeiten zu rechnen ist.

Aus der DE 39 39 165 ist ein Temperatursensor mit einem Meßwiderstand bekannt, bei dem ein als Träger dienendes Keramikplättchen mit einem dünnen Metallüberzug als Widerstandsschicht ausgebildet ist und Kontaktflächen direkt elektrisch leitend und mechanisch fest mit elektrisch voneinander isolierten Leiterbahnen einer Leiterplatine verbunden sind. Als Leiterplatine ist eine Kunststoffolie, bzw. Kaptonfolie vorgesehen, wobei die Leiterbahnen aus Kupfer oder einer Kupferbasis-Legierung bestehen; die in einem Schutzrohr befindliche Leiterplatte ist über Kontaktfelder mit einem äußeren Anschlußkabel verbunden, wobei das Anschlußkabel zwecks Zugentlastung mechanisch fest mit dem Schutzrohr verbunden ist.

Weiterhin ist aus DE 31 27 727 A1 ein Fieberthermometer bekannt, bei dem ein aus zwei Teilwiderständen bestehender Meßwiderstand auf einer Substratplatte in Dünnschichttechnik aufgebracht ist, wobei das Substrat von einer gegen Desinfektionsmittel resistenten Masse umschlossen ist und äußere Anschlußleitungen über Lötstellen mit einem Ende der Substratplatte verbunden sind.

Als problematisch erweisen sich die bekannten Temperatursensoren mit Leiterplatten, falls eine weitgehend automatisierte Montage vorgesehen ist, da die Zuordnung der freien Enden der Anschlußkabel mit den vorgesehenen Lötkontaktflächen eine exakte Positionierung erfordert.

In der Praxis ergeben sich hieraus hohe Anforderungen an die Geschicklichkeit des Montagepersonals.

Weiterhin ist aus dem DE-GM 87 16 103 ein Temperatur-Meßwiderstand bestehend aus einem als Träger dienenden Keramikplättchen mit dünnem Metallüberzug als Widerstandsschicht und Kontaktflächen sowie einer die Widerstandsschicht schützenden Isolierschicht bekannt, welches auf eine Leiterplatine aufgebracht ist. Um eine sichere elektrische und mechanische Verbindung des Meßwiderstandes mit einem Anschlußkabel vorzusehen, sind die Kontaktflächen direkt elektrisch leitend und mechanisch fest mit den Leiterbahnen der Leiterplatine verbunden. Auch wenn eine sichere und weitgehend automatisierte Aufbringung des Meßwiderstandes nach der Beschreibung zu erwarten sind, sind weitergehende Maßnahmen zur Befestigung und Kontaktierung eines Anschlußkabels nicht angegeben.

Weiterhin ist aus DT 24 19 327 A1 ein Verfahren zur elektrischen Kontaktierung von gedruckten Leiterplatten bekannt, bei dem elektrisch isolierte Drähte in Form von Leiterstreifen in Bohrungen von Anschlußstellen der Leiterplatte eingesteckt und mittels Lötpad verbunden werden; durch Verbindung der Leiterstreifen mit Steckern und Griffleisten wird eine Zugentlastung der mit dem Stecker verbundenen Anschlußstellen erzielt; eine eventuelle Zugentlastung der Anschlußstellen auf der Leiterplatine ist nicht vorgesehen.

Aufgabe der Erfindung ist es, eine weitgehend automatisierbare Montage von Leiterplatten, gegebenenfalls in SMD-Technologie zu schaffen; dabei soll eine Verbindung mit Zugentlastung zwischen Leiterplatte und wenigstens einem Anschluß-Leiter erstellt werden; weiterhin soll ein Herstellungsverfahren von Leiterplatten angegeben werden, mit dem eine kostengünstige Fertigung möglich ist.

Darüberhinaus soll ein Verfahren zum Verbinden von Anschluß-Leitern und eine Verwendung der Leiterplatten angegeben werden.

Die Aufgabe wird anordnungsgemäß durch die Merkmale des Anspruchs 1 gelöst.

Als vorteilhaft erweist sich die Möglichkeit des Einsatzes standardisierter Leiterplattenstrukturen. In einer vorteilhaften Ausgestaltung sind Halterungs-Elemente mit kanalartige Ausnehmungen zur Aufnahme ummantelter Kabel-Enden vorgesehen, deren Leiteraustrittsbereich benachbart zu jeweils einer Kontaktfläche angeordnet ist. Hierbei erweist sich die automatisierbare Anschlußmöglichkeit von Anschlußleitern an Kontaktfelder der Leiterbahn als vorteilhaft. Weitere vorteilhafte Ausgestaltungen der Anordnung sind in den Ansprüchen 2 bis 6 angegeben.

Bei Verbindung von zwei oder mehr Kontaktfeldern mit einer Leiterbahn, kann diese vorteilhafterweise als Widerstandsschicht aufgebaut sein.

Weiterhin erweist es sich bei Leiterplatten nach Anspruch 5 als vorteilhaft, daß den jeweiligen Anwendungszwecken angepaßte Standard-Widerstände eingesetzt werden können.

Die Aufgabe wird verfahrensgemäß zur Herstellung einer Leiterplatte durch die Merkmale des Anspruchs 7 gelöst.

Als besonders vorteilhaft erweist sich dabei die robuste Anschlußtechnik der Leitungsverbindungen, wobei die besondere Kabelanschlußtechnik auch auf einfache Weise eine Fertigung in Form eines Nutzens mit einer Feldanordnung von Meßelementen ermöglicht.

Ein wesentlicher Vorteil des Verfahrens ist in der Möglichkeit der automatischen Zusammensetzung von Temperatursensoren zu sehen, darüberhinaus wird eine Qualitätskontrolle wesentlich erleichtert.

Vorteilhafte Ausgestaltungen des Verfahrens sind in den Ansprüchen 8 bis 12 angegeben.

Bei Montage von Meßwiderstand und Verbindung mit dem Anschlußkabel können dabei alle Leiterplattentypen nach einem gleichen Fertigungsschema bestückt werden.

Die Aufgabe wird verfahrensgemäß zum Anschluß von Kabelenden an eine Leiterplatte dadurch gelöst, daß die Leiterplatte in einen Werkstückträger eingebracht und oberhalb einer Löt-Düse mit nach unten gerichteten Kontaktfeldern positioniert wird, wobei das Kabel mittels Greifer mit seinen Leiterenden bis zur Arretierung an einem zwischen den Leiterenden aufragenden Anschlag-Bolzen entlang Leiterplatten-Längsachse so geführt wird, daß die Kabel-Enden mit ihrem Mantel in Ausnehmungen der Halterung eingebracht werden, wobei eine Zugentlastung des Anschlußkabel-Endes durch Quetschung des Außenmantels vom jeweiligen Kabel-Ende in eine U-förmige Ausnehmung erzielt wird und die abisolierten Leiterenden des Kabels sich unterhalb der Kontaktfelder befinden und diese berühren und daß anschließend aus der Lot-Düse ein überlaufender Lot-Schwall auf die Kontaktfelder geführt wird, welcher die abisolierten Leiterenden mit den Kontaktfeldern elektrisch leitend und mechanisch fest verbindet.

Eine vorteilhafte Ausgestaltung des Verfahrens ist gemäß Anspruch 14 auf eine Verbindung von Anschluß-Kabeln mit Leiterplatten gerichtet, die noch als Nutzen ausgebildet sind.

Als besonders vorteilhaft erweist sich die Möglichkeit einer kostengünstigen Fertigung durch gleichzeitige Bearbeitung mehrerer Leiterplatten.

Die Aufgabe wird verwendungsgemäß durch Anspruch 15 für den Einsatz von Temperatur-Sensoren oder Heizelementen gelöst; die Aufgabe wird verwendungsgemäß für den Einsatz von Meß-Elektroden durch Anspruch 16 gelöst.

Im folgenden ist der Gegenstand der Erfindung anhand der Figuren 1, 2, 3, 4, 5 und 6 näher erläutert.
Figur 1 zeigt in einer perspektivischen Darstellung eine Leiterplatte mit einem aufzubringenden Meßwiderstand und den Führungen für die Kabelenden;
Figur 2 zeigt eine Draufsicht auf eine Leiterplatte mit eingesetztem Meßwiderstand und Halterung für die Kabelführung der Kabelenden;
Figur 3 zeigt einen Querschnitt entlang der Schnittfläche AB der Figur 2;
Figur 4 zeigt einen Querschnitt ähnlich wie Figur 3, wobei die Kabel-Enden jedoch mit der Leiterplatte verbunden sind.
Figur 5 zeigt schematisch das Verfahren zur Herstellung der Verbindung zwischen Leiterplatte und Kabel-Ende;
Figur 6 stellt schematisch den Lötvorgang dar.

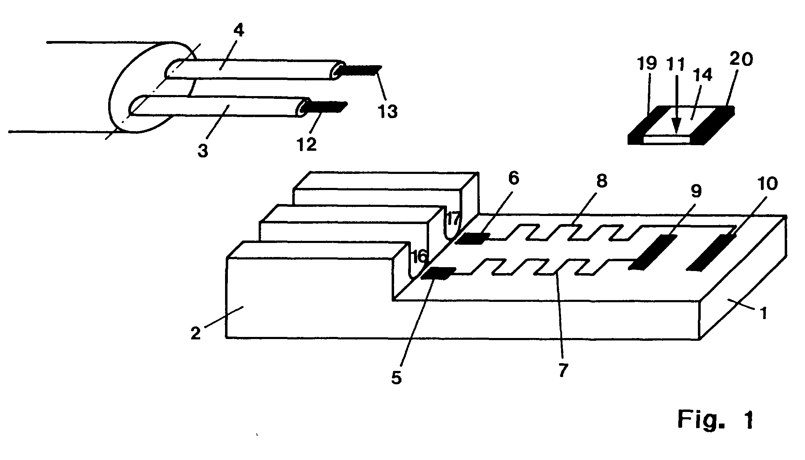

Gemäß Figur 1 weist der Sensor eine als Kunststoffspritzteil ausgebildete Leiterplatte 1 auf, welche eine monolithisch integrierte Halterung 2 zur Aufnahme von Anschlußkabel-Enden 3, 4 sowie Anschlußkontaktfelder 5, 6 für die Verbindung der Anschlußkabel-Enden enthält, die jeweils über mäanderförmige Leiterbahnen 7, 8 mit Anschlußkontaktfeldern 9, 10 für einen Meßwiderstand 11 verbunden sind. Der kurz vor dem Aufsetzen dargestellte Meßwiderstand 11 weist eine elektrische Widerstandsschicht 14 auf, deren Widerstand eine Funktion der Temperatur ist; die ebenfalls kurz vor dem Einsetzen dargestellten Kabel enthalten zwei parallel geführte Anschlußkabel-Enden 3, 4, von denen jeweils ein bzw. zwei Adern 12, 13 mit den Kontaktfeldern 5, 6 verbunden werden sollen, wobei der Außenmantel 15, 18 jeweils in eine oben offene U-förmige, kanalartige Ausnehmung 16, 17 der Halterung 2 eingebracht und unter Quetschung in der Halterung 2 formschlüssig gehalten wird; dabei sollen die innenliegenden Adern 12 bzw. 13 jeweils mit einem der Kontaktfelder 5, 6 verbunden werden. Die Kontaktierung der Anschlußkontaktfelder 5, 6 erfolgt über Leiterbahnen 7, 8 mit den Kontaktfeldern 9, 10, welche zum elektrischen und mechanischen Verbinden der Kontakte 19, 20 von Meßwiderstand 11 vorgesehen sind; die Längsachse der Leiterplatte ist mit Ziffer 26 bezeichnet.

Die Leiterplatte 1 besteht aus einem ebenen Teil zur Aufnahme der Leiterbahnen und Kontaktflächen 5, 6, 7, 8, 9, 10 sowie einer fest integrierten Halterung 2, mit U-förmigen Ausnehmungen 16, 17 zur Einbringung der Anschlußkabel-Enden 3, 4. Die Herstellung eines Rohlings der Leiterplatte 1 erfolgt vorzugsweise aus Kunststoffgranulat im Spritzguß-Verfahren, wobei der dort entstehende Rohling in Form eines Nutzens, d.h. zusammen mit mehreren Rohlingen gleichzeitig durch Spritzguß hergestellt wird und wobei anschließend eine Metallisierung zum Aufbau von Kontaktflächen und Leiterbahnen durch ein Heißprägeverfahren mittels Heißprägefolie erfolgt.

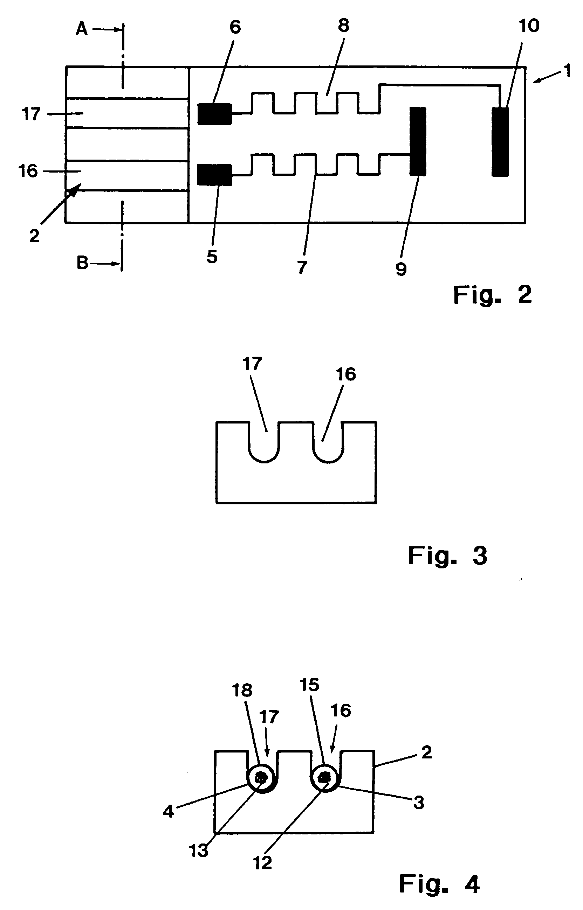

Eine beispielhafte Ausführungsform der Leiterplatte ist anhand der Figur 2 in einer Draufsicht näher erläutert.

Anhand Figur 2 ist die durch Spritzguß erstellte Halterung 2 der Leiterplatte 1 erkennbar, wobei auch von oben die U-förmigen Ausnehmungen 16, 17 zur Halterung der hier nicht gezeigten Kabel-Enden 3, 4 erkennbar sind. Zur mechanischen Verbindung und elektrischen Kontaktierung werden die Adern, wie sie in Figur 1 mit 12, 13 bezeichnet sind, mit den Kontaktfeldern 5, 6 verbunden, wobei gleichzeitig eine Kontaktierung mit den Kontaktfeldern 9, 10 für den Meßwiderstand 11 entsteht. Im Bereich der Kabel-Enden stehen die Adern um ca. 2 bis 4 cm über Kabelrand und Halterung ab, so daß eine einfach automatisierbare Anschlußtechnik entwickelt werden kann.

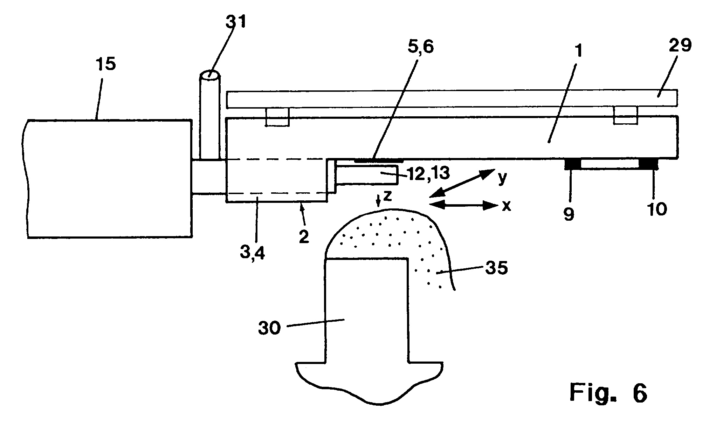

Bei einer automatisierbaren Bestückung werden beispielsweise die Leiter 3, 4 (Figur 1) mit einem Greifer über den Ausnehmungen 16, 17 positioniert und angedrückt. Die Lötung der Adern 12, 13 auf Kontaktfeldern 5, 6 erfolgt automatisch für alle Positionen mit einer selektiven Lötwelle, wie dies nachfolgend anhand Figur 6 erläutert ist;

Figur 3 zeigt den Querschnitt AG gemäß Figur 2 vor der Einbringen der Kabel-Enden.

Anhand des Querschnitts in Figur 4 ist das jeweils in einer U-förmigen Ausnehmung 16, 17 eingebrachte Anschlußkabel-Ende 3, 4 erkennbar, wobei die Adern 12, 13 aus einer Vielzahl von Einzeldrähten bestehen; eine Zugentlastung entsteht praktisch nur durch "Quetschung" der Leitung 3, 4 mit Außenmantel 181, 19 in die U-förmige Ausnehmung 16, 17.

Eine als Widerstandsschicht ausgebildete Leiterbahn kann eine mäanderförmige Struktur aufweisen, wie Sie beispielsweise aus der DE PS 25 27 739 bzw. US PS 4050052 bekannt ist. Als Material der Leiterplatte werden vorzugsweise Kunststoffe der Bezeichnungen PS, ABS und PPS, eingesetzt, wobei sich ABS für Temperaturen bis zu 130 °C, PPS für Temperaturen oberhalb von 150 °C eignet. Leiterbahn und Kontaktfelder bestehen vorzugsweise aus einem Platingruppenmetall.

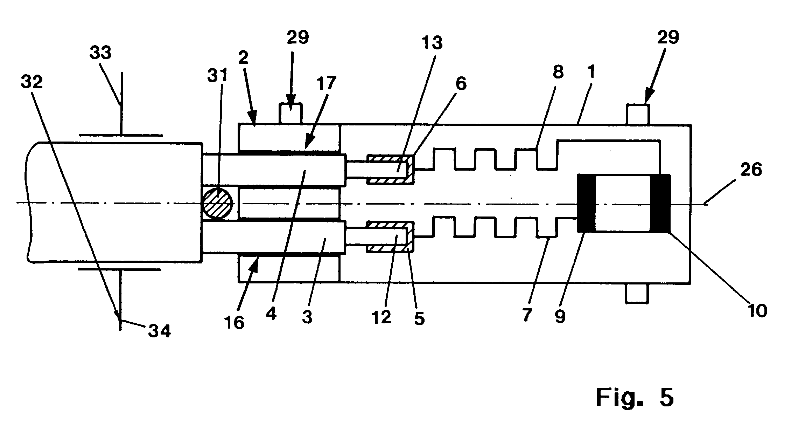

Gemäß Figur 5 wird Leiterplatte 1 in einen Werkstück-Träger eingebracht, der hier symbolisch mit Ziffer 29 angegeben ist. Mit dem Werstück-Träger verbunden sind ein Anschlag-Bolzen 31 sowie eine Greifer-Vorrichtung 32 die mit zwei zangenartig verschiebbaren Greifer-Armen 33, 34 das Kabel-Ende einklemmt und dieses bis zum Erreichen des Anschlag-Bolzens 31 in Richtung Leiterplatte 1 entlang deren Achse 26 führt. Die Leiter-Enden 3, 4 des Anschluß-Kabels werden dabei in die Ausnehmungen 16, 17 des Halterungs-Elements 2 eingebracht bzw. eingeklemmt, wobei die abisolierten Leiter-Enden 12, 13 die Kontaktfelder 5, 6 berühren bzw. überdecken.

Gemäß Figur 6 wird Leiterplatte 1 in dem Werkstück-Träger 29 so positioniert, daß die Kontaktfelder 5, 6 einer Lot-Düse 30 zugekehrt sind, aus der ein schematisch dargestellter Lotschwall 35 austritt, welcher bei Absenkung des Werkstück-Trägers 29 in Z-Richtung die Kontaktfelder zusammen mit den aufliegenden abisolierten Enden 12, 13 der Anschlußleiter-Enden 3, 4 mit Lot benetzt. Weiterhin sind anhand Figur 6 Anschlag-Bolzen 31 zur Positionierung des Kabel-Endes sowie die in Halterungs-Element 2 befindlichen ummantelten Leiter-Enden 3, 4 erkennbar. Nach dem die Kontaktfelder 5, 6 und abisolierten Leiter-Enden 12, 13 mit dem Lötschwall besprüht sind, wird Werkstrück-Träger 29 angehoben und nach Erstarren des Lots eine neue Leiterplatte zur Verbindung mit einem neuen Kabel-Ende aufgenommen. Der Durchmesser der Lot-Düse 30 beträgt ca. 10 mm.

Es ist auch möglich, die Verbindung mehrerer Anschlußkabel für Leiterplatten die sich in einem Nutzen befinden, vorzusehen, wobei dann mehrere parallel geführte Kabel-Enden den Kontaktfeldern des Nutzens zugeführt werden.

Es ist weiterhin möglich die mit dem Anschluß-Kontaktfeld 9, 10 vorgesehenen Meßwiderstände bzw. Heizwiderstände oder Elektroden im gleichen Arbeitsgang mit der Verbindung der Leiter-Enden 12, 13 auf den Anschluß-Kontaktfeldern 5, 6 zu installieren.

Nach Erstarrung und eventueller Vereinzelung sind die Kontaktfelder der Leiter-Platte mit stabilen Anschluß-Leitern bzw. Anschlußkabeln verbunden, die in der weiteren Montagetechnik unproblematisch zu handhaben sind.

## Patentansprüche

1. Leiterplatte, bei der eine elektrisch leitende und mechanisch feste Verbindung der Leiterbahn über Kontaktfelder mit wenigstens zwei gegeneinander elektrisch isolierten Anschluß-Leitern eines Anschluß-Kabels vorgesehen ist, wobei die Kontaktfelder der Leiterbahn an abisolierte Leiter-Enden wenigstens eines ummantelten Anschluß-Kabels durch einen Schmelzvorgang anschließbar sind und wobei das Kabel-Ende in einem gegenüber der Leiterbahn unverrückbar angeordneten Halterungs-Element mit Abstand zur Kontaktfläche der Leiterbahn positionierbar ist, dadurch gekennzeichnet, daß die Leiterbahn (7, 8) wenigstens im Bereich der Kontaktflächen (5, 6) als Ebene ausgebildet ist, wobei sich oberhalb dieser Ebene wenigstens ein Halterungs-Element (2) zur Aufnahme der ummantelten Kabel-Enden erstreckt und das Halterungs-Element (2) als eine Kabel-Durchführung mit kanalartigen Ausnehmungen (16, 17) zur Aufnahme der ummantelten der Kabel-Enden (3, 4) ausgebildet ist, wobei der Querschnitt der kanalartigen Ausnehmungen (16, 17) so gewählt ist, daß das jeweilige Kabel im Querschnitt gesehen vollständig aufgenommen werden kann und jede der kanalartigen Ausnehmungen wenigstens mit einem Leiteraustrittsbereich benachbart zu einem Kontaktfeld (5, 6) der Leiterbahn (7, 8) angeordnet ist.

2. Leiterplatte nach Anspruch 1, dadurch gekennzeichnet, daß das Substrat der Leiterplatte (1) und Halterungs-Element (2) zusammen als monolithisches Bauelement ausgebildet sind.

3. Leiterplatte nach Anspruch 1 oder 2, dadurch gekennzeichnet, daß die Leiter (12, 13) der Kabel-Enden (3, 4) aus den kanalartigen Ausnehmungen (16, 17) des Halterungs-Elements (2) herausragend jeweils an ein Kontaktfeld (5, 6) der Leiterbahn (7, 8) elektrisch und mechanisch fest durch Verlöten anschließbar sind.

4. Leiterplatte nach einem der Ansprüche 1 bis 3, dadurch gekennzeichnet, daß wenigstens zwei Anschlußkontaktfelder (5, 6) mit einer als Widerstandsschicht ausgebildeten Leiterbahn (7, 8) elektrisch verbunden sind.

5. Leiterplatte nach einem der Ansprüche 1 bis 3, dadurch gekennzeichnet, daß wenigstens zwei Anschlußkontaktfelder (5, 6) mit jeweils einer Leiterbahn (7, 8), verbunden sind, die jeweils ein Anschlußkontaktfeld (9, 10) für auflötbare elektrische oder elektronische Bauelemente aufweisen.

6. Leiterplatte nach einem der Ansprüche 1 bis 3, dadurch gekennzeichnet, daß wenigstens zwei Anschlußkontaktfelder (5, 6) mit jeweils einer Leiterbahn (7, 8) verbunden sind, die als Elektroden ausgebildet sind.

7. Verfahren zum Herstellen einer Leiterplatte mit wenigstens einer Leiterbahn sowie damit verbundenen Anschluß-Kontaktfeldern für wenigstens einen Anschluß-Leiter, dadurch gekennzeichnet, daß die Leiterplatte (1) als monolithische Vorform im Spritzgußverfahren aus Kunststoff-Granulat hergestellt wird, wobei ein aus einer von Anschluß-Kontaktfeldern (5, 6) der Leiterbahn (7, 8) gebildeten Ebene herausragendes Halterungs-Element (2) zur Aufnahme wenigstens eines ummantelten Anschluß-Kabel-Endes (3, 4) so ausgebildet wird, daß es wenigstens eine kanalartige Ausnehmung (16, 17) mit einem Kabel-Endaustrittsbereich benachbart zu wenigstens einer Anschluß-Kontaktfläche (5, 6) erhält, wobei die Querschnitte der kanalartigen Ausnehmungen (16, 17) so gestaltet werden, daß die Kabel-Enden (3, 4) vollständig aufgenommen werden können.

8. Verfahren nach Anspruch 7, dadurch gekennzeichnet, daß Leiterbahnen (7, 8) und Anschluß-Kontaktfelder (5, 6; 9, 10) als Metallisierung im Prägeverfahren auf die Vorform aufgebracht werden.

9. Verfahren nach Anspruch 7 oder 8, dadurch gekennzeichnet, daß wenigstens zwei Vorformen von Leiterplatten als Nutzen gleichzeitig im Spritzgußverfahren hergestellt werden.

10. Verfahren nach Anspruch 7 oder 8, dadurch gekennzeichnet, daß die Leiterbahnen (7, 8) und Anschluß-Kontaktflächen (5, 6; 9, 10) mittels einer Heißprägefolie durch Prägestempel auf die Vorform aufgebracht werden.

11. Verfahren nach Anspruch 10, dadurch gekennzeichnet, daß die im Nutzen enthaltenden (Vorform) Einzel-Leiterplatten über Kontaktfelder mit einem Widerstand (11) bestückt, mit den Enden der Anschlußkabel verbunden werden und anschließend vereinzelt werden.

12. Verfahren nach Anspruch 11, dadurch gekennzeichnet, daß der Widerstand (11) durch Kantenmetallisierung für das Auflöten auf die Kontaktfelder (9, 10) vorbereitet wird.

13. Verfahren zum Verbinden von Anschlußleitern eines Kabels mit herausragenden abisolierten Leiter-Enden auf Kontaktfeldern einer Leiterplatte gemäß Anspruch 1, dadurch gekennzeichnet, daß die Leiterplatte (1) in einen Werkstückträger (29) eingebracht und oberhalb einer Löt-Düse (30) mit nach unten gerichteten Kontaktfeldern (5, 6) positioniert wird, wobei das Kabel mittels Greifer (32) mit seinen Leiterenden bis zur Arretierung an einem zwischen den Leiterenden aufragenden Anschlag-Bolzen (31) entlang Leiterplatten-Längsachse (26) so geführt wird, daß die Kabel-Enden (3, 4) mit ihrem Mantel in Ausnehmungen (16, 17) der Halterung (2) eingebracht werden, wobei eine Zugentlastung des Anschlußkabel-Endes durch Quetschung des Außenmantels (18, 19) von Kabel-Ende (3, 4) in eine U-förmige Ausnehmung (16, 17) erzielt wird und die abisolierten Leiterenden (12, 13) des Kabels sich unterhalb der Kontaktfelder (5, 6) befinden und diese berühren und daß anschließend aus der Lot-Düse (30) ein überlaufender Lot-Schwall (35) auf die Kontaktfelder (5, 6) geführt wird, welcher die abisolierten Leiterenden (12, 13) mit den Kontaktfeldern (5, 6) elektrisch leitend und mechanisch fest verbindet.

14. Verfahren nach Anspruch 13, dadurch gekennzeichnet, daß wenigstens zwei Leiterplatten (1) als Nutzen in einen Werkstück-Träger eingebracht werden, und daß wenigstens zwei Greifer zwei Anschluß-Kabel-Enden parallel in Halterungen einführen und abisolierte Leiterenden jeweils mit Kontaktfeldern verbunden werden.

15. Verwendung einer Leiterplatte nach einem der Ansprüche 1 bis 5 als Temperatur-Sensor und/oder Heizer.

16. Verwendung einer Leiterplatte nach Anspruch 6 zur Kapazitäts-Messung.
